Europäisches Patentamt

**European Patent Office**

**Office européen des brevets**

(11) Numéro de publication : **0 025 749**
**B1**

(12) **FASCICULE DE BREVET EUROPÉEN**

(45) Date de publication du fascicule du brevet :
05.09.84

(21) Numéro de dépôt : 80401268.0

(22) Date de dépôt : 05.09.80

(51) Int. Cl.³ : **H 01 S 3/19**

(54) **Procédé de fabrication d'un laser à semiconducteur à confinements transverses optique et électrique et laser obtenu par ce procédé.**

(30) Priorité : 11.09.79 FR 7922650

(43) Date de publication de la demande :
25.03.81 Bulletin 81/12

(45) Mention de la délivrance du brevet :
05.09.84 Bulletin 84/36

(84) Etats contractants désignés :
**DE GB IT NL**

(56) Documents cités :
FR-A- 2 357 088
FR-A- 2 440 616
**IEEE JOURNAL OF QUANTUM ELECTRONICS vol. QE-15, no. 8, août 1979 New York US J.C. BOULEY et al.: "A stabilised zinc diffused-proton bombarded (GaA1)As laser", pages 767-771**
**JAPANESE JOURNAL OF APPLIED PHYSICS vol. 16, no. 1, 1977 Tokyo JP H. YONEZU et al.: "New stripe geometry laser with high quality lasing characteristics by horizontal traverse mode stabilisation a refractive index guiding with Zn doping", pages 209-210**
**ELECTRONIC LETTERS; vol. 15, no. 4, février 1979 Hitching Herts GB G.H.B. THOMPSON et al.: "Twin-transverse-junction stripe laser with linear light current characteristic and low treshold", pages 133-134**
**OPTICAL COMMUNICATION CONFERENCE September 17-19, 1979 Amsterdam NL J. LANDREAU et al.: "GaA1As stripe laser with stable transverse mode structure", pages 2.4-1 - 2.4-4**

(73) Titulaire : **Bouley, Jean-Claude**
**35, Avenue du DR. Durand**
**F-94110 Arcueil (FR)**

**Delpech, Philippe**
**37, rue Louise Michel**
**F-94800 Villejuif (FR)**

**Landreau, Jean**
**107, Avenue de Verdun**
**F-92130 Issy Les Moulineaux (FR)**

(72) Inventeur : **Bouley, Jean-Claude**
**35, Avenue du DR. Durand**
**F-94110 Arcueil (FR)**
Inventeur : **Delpech, Philippe**
**37, rue Louise Michel**
**F-94800 Villejuif (FR)**
Inventeur : **Landreau, Jean**
**107, Avenue de Verdun**
**F-92130 Issy Les Moulineaux (FR)**

(74) Mandataire : **Mongrédien, André et al**
**c/o BREVATOME 25, rue de Ponthieu**
**F-75008 Paris (FR)**

Jouve, 18, rue St-Denis, 75001 Paris, France

## Description

La présente invention a pour objet un procédé de fabrication d'un laser à semiconducteur et un laser obtenu par ce procédé. Elle trouve une application notamment en télécommunications optiques.

Le laser à semiconducteur objet de la présente invention est du type à double hétérostructure. Une telle structure comprend un substrat monocristallin sur lequel sont déposées, par épitaxie en phase liquide, quatre couches de matériaux semiconducteurs, successivement constituées par :
— une première couche, dite de confinement, dopée n,
— une seconde couche, dite active, généralement à base d'arséniure de gallium dopé p,
— une troisième couche, dite de confinement, dopée p,
— une quatrième couche, dite de contact et dopée $p^+$.

Selon une technique connue, on réduit la surface de la zone optiquement active, en la limitant à un mince ruban obtenu en rendant électriquement neutre une partie des troisième et quatrième couches. Cette neutralisation est réalisée en soumettant à un bombardement protonique la structure préalablement recouverte d'un masque correspondant au ruban désiré.

On connaît en particulier des lasers de ce type émettant vers 0,85 $\mu$m et qui comprennent :
— une première couche de confinement, de composition $Ga_{1-x}Al_xAs$, où x est un nombre inférieur à 1 (en général compris entre 0,3 et 0,5), cette couche étant dopée n,
— une seconde couche, active, de composition $Ga_{1-y}Al_yAs$ (avec y en général inférieur à 0,1), cette couche étant le plus souvent dopée p,
— une troisième couche, de confinement, de composition $Ga_{1-z}Al_zAs$, où z est un nombre inférieur à 1, cette couche étant elle aussi dopée p,
— et enfin, une quatrième couche, de contact, de composition GaAs et dopée $p^+$.

Pour plus de détails sur ces structures connues et sur les matériaux utilisés, on pourra se reporter, par exemple à l'article de J. P. NOBLANC intitulé « Fiber Optical Communications Devices » publié dans la revue « Applied Physics », 13, 211-223 (1977) ou à l'ouvrage de H. KRESSEL et J. K. BUTLER intitulé « Semiconductor Laser and Heterojunction Leds » publié par Academic Press.

La structure en ruban permet de limiter l'étendue de la région excitée électriquement à une surface rectangulaire de quelques microns de large (environ 10 $\mu$m) et de quelques centaines de microns de long (300 à 500 $\mu$). Les courants de seuil d'apparition de l'émission laser deviennent alors compatibles avec un fonctionnement en continu à température ambiante.

De nombreuses techniques ont été mises au point pour réaliser de tels rubans. On peut les classer en deux catégories :

a) la première dans laquelle le guidage du faisceau optique est assuré par le profil du gain d'amplification (lasers à guidage par le gain). Ce sont les lasers les plus courants. La technologie utilisée peut faire appel à :
— un bombardement protonique, comme décrit dans l'article intitulé « Optical and electrical properties of proton bombardment p-type GaAs » publié par J. C. DYMENT et al dans la revue « Journal of Applied Physics » vol. 44, N° 1, janvier 1973, p. 207-213,
— une ouverture d'une fenêtre dans la couche de contact à l'aide d'une couche de silice, comme décrit dans l'article intitulé « Advances in GaAs junction lasers with stripe geometry » publié par L. A. D'ASARO dans la revue « Journal of Luminescence », vol. 7, p. 310-337, 1973,
— une diffusion sélective de zinc, comme décrit dans l'article intitulé « A GaAs-$Al_xGa_{1-x}As$ Double Heterostructure Planar Stripe Lasers » par H. YONEZU et al, publié dans la revue « Japanese Journal of Applied Physics » vol. 12, N° 10, p. 1585-1592, octobre 1973.

b) La seconde dans laquelle le guidage du faisceau optique est assuré par un gradient d'indice de réfraction (lasers à guidage par l'indice). Il s'agit, le plus souvent, d'une marche d'indice, celui-ci étant plus élevé dans le ruban qu'à l'extérieur. Ce type de laser présente, par rapport aux lasers à guidage par le gain, une meilleure linéarité de la puissance optique émise en fonction du courant. De nombreuses structures lasers à guidage par l'indice ont été rapportées dans la littérature. On peut citer par exemple :
— le laser à structure « C.S.P. » (abréviation de « Channel Substrate Planar ») décrit dans l'article intitulé « Channel-substrate planar structure (AlGa) As injection lasers » publié par K. AIKI et al, et publié dans la revue « Applied Physics Letters », vol. 30, N° 12, p. 649-651, 15 juin 1977. Dans un tel laser, le profil d'indice est obtenu grâce à la réalisation, dans le substrat, d'un canal de quelques microns de large, la couche de confinement, de type n, possédant alors une épaisseur variable qui induit un saut d'indice au niveau du canal ;
— le laser à diffusion sélective de zinc dans la région active, qui provoque une marche d'indice par compensation électronique des impuretés présentes. Une telle technique est décrite dans l'article intitulé « New Stripe Geometry Laser with High Quality Lasing Characteristics by Horizontal Transverse Mode Stabilisation-A refractive Index Guiding with Zn Doping » par H. YONEZU et al, publié dans la revue « Japanese Journal of Applied Physics », vol. 16, N° 1, p. 209-212, 1977 ;
— le laser « enterré » où la partie active en GaAs est complètement entourée de GaAlAs d'indice optique plus faible que GaAs ; un tel laser est décrit dans l'article intitulé « GaAs-$Ga_{1-x}Al_xAs$ buried-heterostructure injection lasers » publié par T. TSUKADA dans la revue « Journal of Applied Physics », vol. 45, N° 11, p. 4899-4906, novembre 1974.

**0 025 749**

— enfin, le laser décrit dans l'article de J. C. BOULEY et al intitulé « A stabilized zinc Diffused-Proton Bombarded (GaAl) As Laser » et publié dans IEEE Quantum Electronics — August 1979, qui décrit un laser à guidage par l'indice dans lequel une marche d'indice est obtenue par diffusion de zinc, mais cette diffusion affectant les côtés du ruban.

Les lasers à profil d'indice conduisent tous à un certain nombre de difficultés technologiques. Ces difficultés peuvent tenir à la nécessité d'effectuer une épitaxie liquide en deux étapes, (cas du laser à structure enterrée), ou bien au fait que la profondeur de diffusion doit être contrôlée avec précision, (cas du laser à « diffusion sélective ») ou bien encore à l'obtention d'un alignement du ruban optique et du ruban électrique où s'effectue le pompage, (cas du laser « C.S.P. »).

Dans le procédé décrit par J. C. BOULEY et al on forme une double hétérostructure avec une couche de contact au sommet, puis on grave une mésa dans la couche de contact et l'on utilise cette mésa comme masque pour une opération de diffusion de zinc. On dépose ensuite sur cette mésa un masque en photorésist apte à bloquer les protons dans une opération de bombardement protonique. On décape ensuite chimiquement le masque en photorésist situé sur la mésa, pour dégager le sommet de la couche de contact.

Un tel procédé présente l'inconvénient de laisser subsister une mésa au-dessus du ruban, qui est la mésa formée dans la couche de contact. La structure obtenue n'est donc pas plane, ce qui pose des problèmes lors de la soudure de l'ensemble sur son embase. En outre, la nécessité de déposer un masque sur le sommet de la mésa avant le bombardement protonique est une source de difficultés car il faut que ce masque soit rigoureusement aligné sur la mésa si l'on veut que le ruban non bombardé et le ruban non diffusé soient alignés.

Le but de la présente invention est de proposer un nouveau procédé de fabrication d'un laser à hétérostructure du genre de ceux dans lesquels on effectue un bombardement protonique et une diffusion de zinc, mais dans lequel s'opère un auto-alignement des rubans non diffusé et non bombardé, ce qui favorise une réduction du courant de fonctionnement du laser, ce procédé conduisant en outre à une structure plane, qui facilite le montage du dispositif.

Ce but est atteint, selon l'invention, par la suite des opérations suivantes :

1) On forme une double hétérostructure classique (substrat de type n, première couche de confinement n, couche active, deuxième couche de confinement et couche de contact $p^+$) ; toutefois, la couche active est de type n faiblement dopée ;

2) On dépose sur la couche de contact de composition GaAs une couche de masquage de composition voisine de celle des couches de confinement ;

3) On attaque chimiquement cette dernière couche pour ne laisser subsister qu'une « mésa » de masquage de composition $Ga_{1-y}Al_yAs$ avec y compris entre 0,5 et 0,7 et d'épaisseur suffisante pour arrêter à la fois une diffusion de zinc et un bombardement protonique affectant, dans les parties non masquées, les trois dernières couches (14, 16, 18) ;

4) On effectue une diffusion de zinc en prenant cette « mésa » comme masque, le temps de diffusion étant suffisamment grande pour que la diffusion affecte la zone active, de manière à inverser les parties latérales en type p tout en laissant subsister une partie centrale faiblement dopée n ;

5) On effectue un bombardement protonique de la structure en prenant encore la « mésa » comme masque, la zone bombardée s'étendant elle aussi au-delà de la zone active, la zone bombardée de la couche active étant comprise dans la zone diffusée de cette couche active, de telle manière qu'il subsiste deux homojonctions latérales (30, 32) ;

6) On supprime la « mésa » par attaque chimique sans attaquer la couche de contact de manière à obtenir une structure plane facilitant le montage du dispositif.

La structure obtenue résulte directement de ces opérations. Il s'agit d'un laser à double hétérostructure avec une couche active qui présente une partie centrale faiblement dopée n (là où la diffusion de zinc est inexistante) et des parties latérales dopées p (du fait de la diffusion). D'où :

— une distribution d'indice de réfraction en forme de marche, qui améliore les conditions de propagation du rayonnement lumineux en provoquant un confinement transverse optique,

— deux homojonctions latérales qui provoquent un confinement transverse électrique.

De toute façon, les caractéristiques de l'invention apparaîtront mieux après la description qui suit, d'un exemple de réalisation donné à titre explicatif et nullement limitatif. Cette description se réfère à des dessins annexés sur lesquels :

les figures 1 à 5 illustrent les étapes successives du procédé de fabrication de l'invention,

la figure 6 représente en coupe la structure finale obtenue.

Les différentes étapes du procédé sont les suivantes :

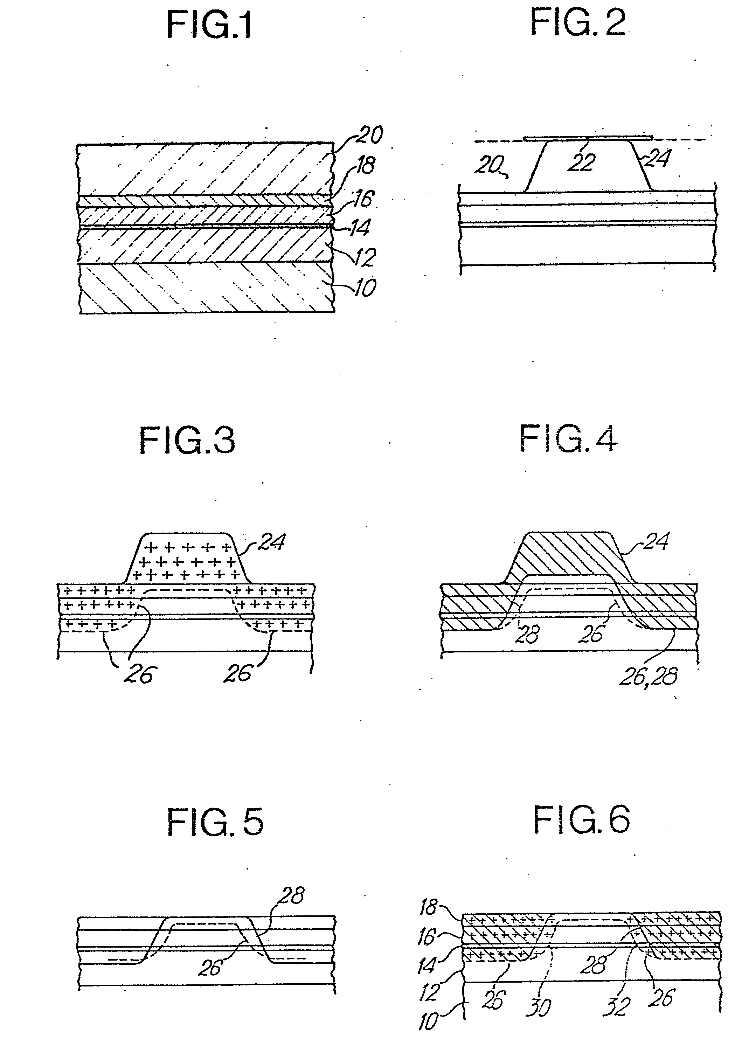

1) formation d'une double hétérostructure par épitaxie en phase liquide (figure 1). Cette structure comprend :

— un substrat 10,

— une première couche de confinement 12,

— une couche active 14,

— une deuxième couche de confinement 16,

— une couche de contact 18,

— et enfin, une couche de masquage 20.

3

0 025 749

Le tableau ci-joint résume les caractéristiques des différentes couches, les valeurs indiquées n'étant données naturellement qu'à titre explicatif ;

2) dépôt d'une couche de résine 22 ; puis traitement de cette couche par photogravure et attaque chimique par une solution $H_2O_2$, $H_2SO_4$, $H_2O$ (8, 1, 1 volumes à 10 °C, vitesse d'attaque 0,1 $\mu$m/s) pour ne laisser subsister qu'un ruban 24 d'environ 20 $\mu$m de large dans la couche de masquage 22 (figure 2) ;

3) diffusion de zinc effectuée en ampoule scellée avec une vapeur de zinc saturée à 590 °C. La vitesse de diffusion dépend de la nature des matériaux. Après une heure de diffusion, on obtient une profondeur de 2,9 $\mu$m dans GaAlAs et 1,2 $\mu$m dans GaAs. Le front de diffusion est ajusté pour dépasser la zone active 14 de 1 $\mu$m environ, cela dans les régions latérales non masquées par le ruban 24. Le profil de la zone diffusée porte la référence 26 sur la figure 3 et le volume diffusé est marqué par des croix ;

4) bombardement protonique (figure 4). Ce bombardement est effectué en utilisant des protons d'énergie 300 keV. Le profil d'implantation porte la référence 28. Ce profil est sensiblement rectiligne sous la mésa de masquage alors que le profil 26 de diffusion est légèrement arrondi, du fait de la diffusion du zinc sous la mésa. Le ruban non implanté est donc légèrement plus large que le ruban non diffusé. En dehors de la zone masquée la région bombardée a sensiblement la même épaisseur que la région diffusée et les profils 26 et 28 coïncident ;

5) suppression du ruban de masquage (figure 5). Cette opération s'effectue par attaque chimique avec de l'acide fluorhydrique pur, en quelques minutes, l'acide n'attaquant pas la couche de GaAs en surface. La prise des contacts sur les parties p et n de la structure et le montage s'effectuent ensuite comme dans les lasers classiques.

La structure est illustrée en coupe sur la figure 6. Dans la couche active 14 on trouve, à la frontière entre le canal central faiblement dopé n et les régions latérales dopées p, deux homojonctions 30 et 32 délimitant latéralemement le canal et permettant un confinement électrique transverse. Ces homojonctions coïncident avec les zones de changement d'indice, provoquant, elles, le confinement optique. En outre, il est clair que le fait d'utiliser un seul masque 24 pour les deux opérations d'implantation et de diffusion entraîne ipso facto un auto-alignement des zones implantées et diffusées.

L'utilisation, selon l'invention, d'une diffusion de zinc pour créer une marche d'indice peut, à certains égards, rappeler la technique décrite par H. YONEZU et al dans l'article cité plus haut. En réalité, les deux techniques sont très différentes pour les raisons suivantes. Dans la technique antérieure, la couche active est dopée n et la diffusion de zinc affecte le ruban actif puisqu'il s'agit de réduire le dopage de ce ruban tout en préservant son caractère n. La couche active présente alors partout un dopage de type n, avec une valeur moindre dans la zone centrale siège de l'émission stimulée. Comme l'indice de réfraction est d'autant plus fort que le dopage n est plus faible, il en résulte une marche d'indice avec un indice fort dans le ruban et un indice faible dans les zones latérales.

Une telle technique pose de nombreux problèmes puisqu'il s'agit d'aller compenser de manière fine la couche active, ce qui suppose un contrôle extrêmement précis de la profondeur de diffusion de zinc. De plus, la compensation affecte précisément la zone où a lieu l'émission stimulée, ce qui est peu judicieux puisque tout défaut d'homogénéité dans cette zone se traduit immédiatement par des anomalies sur le faisceau optique.

La technique conforme à l'invention évite cet écueil en préconisant une diffusion de zinc en dehors du ruban actif. En outre, il ne s'agit plus de compenser légèrement le dopage n de la couche active, mais de donner à celui-ci un caractère p nettement marqué. La contrainte sur la profondeur de diffusion est alors beaucoup moins grande. Enfin, et comme on l'a vu plus haut, le caractère p des zones latérales diffusées, combiné au caractère n du ruban central, fait apparaître deux homojonctions dans la couche active qui viennent délimiter électriquement le ruban actif, avec les avantages déjà soulignés.

Quant à la technique décrite par J. C. BOULEY et al dans l'article cité plus haut, il s'agit d'accentuer le dopage p de la couche active en dehors du ruban actif. En effet, l'indice est d'autant plus fort que le dopage p est faible. Selon cette technique, on n'agit pas sur la zone active, ce qui réduit les difficultés inhérentes au réglage de la profondeur de diffusion, mais on n'obtient pas d'homojonctions puisque la couche active reste dopée p sur toute sa surface.

(Voir tableau page 5)

4

Tableau

| Identité de la couche | Référence numérique sur les figures | Composition | Dopage | | | Epaisseur µm |
|---|---|---|---|---|---|---|
| | | | dopant | type | dopage $cm^{-3}$ | |
| Couche de masquage | 20 | $Ga_{0,4}Al_{0,6}As$ | Ge | (p) | $10^{18}$ | 6 |
| Couche de contact | 18 | Ga As | Ge | (p) | $10^{19}$ | 0,5 |
| Deuxième couche de confinement | 16 | $Ga_{0,65}Al_{0,35}As$ | Ge | (p) | $10^{18}$ | 1 |
| Couche active | 14 | Ga As | | (n) | $10^{16}$ | 0,2 |
| Première couche de confinement | 12 | $Ga_{0,65}Al_{0,35}As$ | Sn | (n) | $10^{17}$ | 4 |
| Substrat | 10 | Ga As | Si | (n) | $10^{18}$ | 100 |

0 025 749

**0 025 749**

Revendications

1. Procédé de fabrication d'un laser à semiconducteur du type à profil d'indice à double hétérostructure et à structure plane, du genre de ceux dans lesquels on effectue un bombardement protonique et une diffusion de zinc, comprenant sur un substrat (10) une première couche de confinement (12), une couche active (14), une deuxième couche de confinement (16), et une couche de contact (18), caractérisé en ce que :

1) on forme une telle double hétérostructure en constituant une couche active (14) faiblement dopée n,

2) on dépose sur la couche de contact (18) de composition GaAs une couche de masquage (20) de composition $Ga_{1-y}Al_yAs$ avec y compris entre 0,5 et 0,7, et d'épaisseur suffisante pour arrêter à la fois une diffusion de zinc et un bombardement protonique affectant dans les parties non masquées les trois dernières couches (14, 16, 18),

3) on attaque chimiquement cette dernière couche sans attaquer la couche de contact (18) pour ne laisser subsister qu'une « mésa » de masquage (24),

4) on effectue une diffusion de zinc en prenant cette « mésa » (24) comme masque, le temps de diffusion étant suffisamment grand pour que la diffusion affecte la couche active (14), de manière à inverser les parties latérales en type p tout en laissant subsister une partie centrale faiblement dopée n,

5) on effectue un bombardement protonique en prenant encore cette « mésa » (24) comme masque, la zone bombardée s'étendant elle aussi au-delà de la couche active (14), la zone bombardée de la couche active étant comprise dans la zone diffusée de cette couche active, de telle manière qu'il subsiste deux homojonctions latérales (30, 32),

6) on supprime la « mésa » par attaque chimique sans attaquer la couche de contact (18), de manière à obtenir une structure plane facilitant le montage du dispositif.

2. Procédé selon la revendication 1, caractérisé en ce qu'on forme par épitaxie en phase liquide une double hétérostructure comprenant : un substrat (10) en GaAs dopé n, une première couche de confinement (12) de composition $Ga_{1-x}Al_xAs$ avec x compris entre 0,3 et 0,5 dopée n, une couche active (14) de composition $Ga_{1-y}Al_yAs$ avec y inférieur à 0,1, cette couche étant faiblement dopée n, une deuxième couche de confinement (16) de composition $Ga_{1-x}Al_xAs$ dopée p, une couche de contact (18) en GaAs fortement dopée $p^+$.

3. Laser à semiconducteur du type à profil d'indice à double hétérostructure et à structure plan du genre de ceux qui comprennent une double hétérostructure constituée par un substrat (10), une première couche de confinement (12), une couche active (14), une deuxième couche de confinement (16) et une couche de contact (18), les trois dernières couches (14, 16, 18) ayant subi une neutralisation par bombardement protonique sauf le long d'un étroit ruban localisé au centre de la structure, la double hétérostructure ayant subi également une diffusion localisée de zinc, caractérisé en ce que la couche active (16) présente dans la partie centrale du ruban, un dopage faible de type n et, sur les bords du ruban dans la zone n'ayant pas subi le bombardement, une région dopée rendue de type p par ladite diffusion de zinc, deux homojonctions latérales (30, 32) apparaissant ainsi sur les bords du ruban, définissant deux zones à changement d'indice de réfraction, définissant ainsi une partie centrale dans la couche active à indice plus élevé.

4. Laser selon la revendication 3, caractérisé en ce que : le substrat (10) est en GaAs dopé n, la composition de la première couche de confinement (12) est $Ga_{1-x}Al_xAs$ avec x compris entre 0,3 et 0,5 et son dopage est n, la composition de la couche active (14) est $Ga_{1-y}Al_yAs$ avec y inférieur à 0,1 et son dopage est n, la composition de la deuxième couche de confinement (16) est $Ga_{1-x}Al_xAs$ et son dopage est p, la couche de contact (18) est en GaAs et dopée $p^+$.

Claims

1. Process for the manufacture of a semiconductor laser of the index profile type, having a double heterostructure and a planar structure, of the type employing proton bombardment and zinc diffusion, comprising a substrate (10) on which are a first confinement layer (12), an active layer (14), a second confinement layer (16), and a contact layer (18), characterized in that :

1) a double heterostructure is formed to constitute an active layer (14) which is weakly n-doped,

2) a masking layer (20) is deposited on the contact layer (18) whose composition is GaAs, said masking layer (20) having the composition $Ga_{1-y}Al_yAs$, wherein y is between 0.5 and 0.7, and having a thickness sufficient to halt both zinc diffusion and proton bombardment which affect the three last layers (14, 16, 18) in the non-masked parts,

3) said last layer is subjected to chemical attack, without attack on the contact layer (18), whereby to leave a single masking « mesa » (24),

4) zinc diffusion is carried out, using said « mesa » (24) as a mask, the diffusion time being large enough for diffusion to affect the active layer (14), whereby to invert the side parts into p-type while leaving a weakly n-doped central part,

5) proton-bombardment is carried out, again using said « mesa » (24) as a mask, the bombarded

**0 025 749**

zone also extending beyond the active layer (14), the bombarded zone of the active layer being comprised within the diffused zone of said active layer, whereby two lateral homojunctions (30, 32) are formed, and

6) the « mesa » is removed by chemical attack without attacking the contact layer (18), whereby to obtain a flat structure facilitating mounting of the apparatus.

2. Process according to Claim 1, characterized in that epitaxial growth in liquid phase is employed to form a double heterostructure comprising : a substrate (10) of n-doped GaAs, a first confinement layer (12) n-doped and having the composition $Ga_{1-x}Al_xAs$ wherein x is between 0.3 and 0.5, an active layer (14) having the composition $Ga_{1-y}Al_yAs$ wherein y is less than 0.1, said layer being weakly n-doped, a second confinement layer (16) p-doped and having the composition $ga_{1-x}Al_xAs$, and a contact layer (18) of strongly $p^+$-doped GaAs.

3. A semiconductor laser of the index profile type, having a double heterostructure and a planar structure, of the type comprising a double heterostructure constituted by a substrate (10), a first confinement layer (12), an active layer (14), a second confinement layer (16) and a contact layer (18), the three latter layers (14, 16, 18) having been subjected to neutralization by proton-bombardment except along the length of a narrow stripe located at the centre of the structure, the double heterostructure having also been subjected to localized zinc-diffusion, characterized in that the active layer (16) exhibits weak n-type doping in the central part of the stripe, and, on the sides of the stripe which were not subjected to bombardment, a doped region converted into the p-type by said zinc diffusion, two lateral homojunctions (30, 32) thereby being formed at the sides of the stripe, defining two zones of refractive index-change, thus defining a central portion of increased refractive index in the active layer.

4. A laser according to Claim 3, characterized in that the substrate (10) comprises n-doped GaAs, the first confinement layer (12) is n-doped with a composition $Ga_{1-x}Al_xAs$ wherein x is between 0.3 and 0.5, the active layer (14) is n-doped with a composition $Ga_{1-y}Al_yAs$ wherein y is less than 0.1, the second confinement layer is p-doped with a composition $Ga_{1-x}Al_xAs$, and the contact layer (18) comprises $p^+$-doped GaAs.


### Ansprüche

1. Verfahren zur Herstellung eines Halbleiterlasers, vom Typ mit einem Brechungsindexprofil, mit doppelter Heterostruktur und mit ebener Struktur, bei dem ein Beschuß mit Protonen und eine Diffusion von Zink durchgeführt werden, wobei ein Substrat (10), eine erste Begrenzungsschicht (12) eine aktive Schicht (14), eine zweite Begrenzungsschicht (16) und eine Kontaktschicht (18) vorgesehen sind, dadurch gekennzeichnet, daß

1) eine solche doppelte Heterostruktur erzeugt wird, indem eine schwach n-dotierte, aktive Schicht (14) ausgebildet wird,

2) auf der Kontaktschicht (18) aus GaAs eine Maskierungsschicht (20) aus $Ga_{1-y}Al_yAs$ aufgebracht wird, wobei y zwischen 0,5 und 0,7 liegt, deren Dicke ausreichend ist, um zugleich eine Diffusion von Zink und einen Protonenbeschuß zu stoppen, welche auf die maskenfreie Bereiche der drei letzten Schichten (14, 16, 19) wirken,

3) auf diese letzte Schicht chemisch eingewirkt wird, ohne auf die Kontaktschicht (18) einzuwirken, um nur eine « Mesa » als Maske (24) stehen zu lassen,

4) eine Diffusion von Zink durchgeführt wird, wobei diese « Mesa » (24) als Maske verwendet wird und die Diffusionszeit ausreichend groß ist, damit die Diffusion auf die aktive Schicht (14) derart wirkt, daß die Seitenabschnitte zum p-Typ umgekehrt werden, wobei ein mittlerer, schwach n-dotierter Bereich bestehen gelassen wird,

5) ein Protonenbeschuß durchgeführt wird, wobei diese « Mesa » (24) wieder als Maske verwendet wird und sich der dem Beschuß ausgesetzte Bereich auch über die aktive Schicht (14) hinaus erstreckt und der dem Beschuß ausgesetzte Bereich der aktiven Schicht von dem diffundierten Bereich dieser aktiven Schicht derart umfaßt wird, daß zwei seitliche Homoübergänge (30, 32) übrig bleiben,

6) die « Mesa » durch chemisches Einwirken entfernt wird, ohne daß auf die Kontaktschicht (18) eingewirkt wird, derart, daß eine ebene Struktur erhalten wird, die die Befestigung der Einrichtung erleichtert.

2. Verfahren nach Anspruch 1, dadurch gekennzeichnet, daß durch Epitaxie aus der Flüssigkeitsphase eine doppelte Heterostruktur ausgebildet wird, welche ein n-dotiertes Subtrat (10) aus GaAs, eine erste, n-dotierte Begrenzungsschicht (12) aus $Ga_{1-x}Al_xAs$, mit x zwischen 0,3 und 0,5, eine aktive Schicht (14) aus $Ga_{1-y}Al_yAs$, mit y niedriger als 0,1, wobei diese Schicht leicht n-dotiert ist, eine zweite p-dotierte Begrenzungsschicht (16) aus $Ga_{1-x}Al_xAs$ sowie eine stark $p^+$-dotierte Kontaktschicht (18) aus GaAs umfaßt.

3. Halbleiterlaser, vom Typ mit einem Brechungsindexprofil, mit doppelter Heterostruktur und mit ebener Struktur, der eine doppelte Heterostruktur umfaßt, die gebildet ist aus einem Subtrat (10), einer ersten Begrenzungsschicht (12), einer aktiven Schicht (14), einer zweiten Begrenzungsschicht (16) und einer Kontaktschicht (18), wobei die drei letzten Schichten (14, 16, 18) einer Neutralisierung durch Protonenbeschuß mit Ausnahme eines in der Mitte der Struktur angeordneten, dünnen Bandes ausgesetzt worden sind und die doppelte Heterostruktur auch einer beschränkten Diffusion von Zink ausgesetzt worden ist, dadurch gekennzeichnet, daß die aktive Schicht (16) im mittleren Bereich des Bandes eine schwache Dotierung vom n-Typ und an den Rändern des Bandes in dem Bereich, welcher dem Beschuß nicht ausgesetzt war, einen dotierten Bereich aufweist, der durch die Diffusion von Zink zum p-Typ wurde, und daß zwei seitliche Homoverbindungen (30, 32), die somit an den Rändern des Bandes auftreten, zwei Änderungsbereiche des Brechungsindex festlegen, so daß somit ein mittlerer Bereich in der aktiven Schicht mit einem höheren Brechungsindex festgelegt wird.

4. Laser nach Anspruch 3, dadurch gekennzeichnet, daß das Substrat (10) aus n-dotiertem GaAs besteht, die Zusammensetzung der ersten Begrenzungsschicht (12) aus $Ga_{1-x}Al_xAs$ mit x zwischen 0,3 und 0,5 und einer n-Dotierung besteht, die Zusammensetzung der aktiven Schicht (14) aus $Ga_{1-y}Al_yAs$ mit y kleiner als 0,1 und einer n-Dotierung besteht, die Zusammensetzung der zweiten Begrenzungsschicht (16) aus $Ga_{1-x}Al_xAs$ und einer p-Dotierung und die Kontaktschicht (18) aus GaAs und einer $p^+$-Dotierung besteht.

# FIG.1

# FIG. 2

# FIG.3

# FIG.4

# FIG.5

# FIG.6

1